(19) Europäisches Patentamt
European Patent Office
Office européen des brevets

(11) **EP 4 546 997 A1**

(12) **EUROPEAN PATENT APPLICATION**
published in accordance with Art. 153(4) EPC

(43) Date of publication:
**30.04.2025 Bulletin 2025/18**

(51) International Patent Classification (IPC):
**H10N 10/13** $^{(2023.01)}$    **H10N 10/17** $^{(2023.01)}$
**H10N 10/852** $^{(2023.01)}$

(21) Application number: **23827026.8**

(22) Date of filing: **09.06.2023**

(52) Cooperative Patent Classification (CPC):
**H10N 10/13; H10N 10/17; H10N 10/852**

(86) International application number:
**PCT/JP2023/021618**

(87) International publication number:
**WO 2023/248840 (28.12.2023 Gazette 2023/52)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **24.06.2022 JP 2022101948**

(71) Applicant: **Panasonic Intellectual Property Management Co., Ltd.**
**Kadoma-shi, Osaka 571-0057 (JP)**

(72) Inventor: **TAMAKI, Hiromasa**
**Kadoma-shi, Osaka 571-0057 (JP)**

(74) Representative: **Novagraaf International SA**
**Chemin de l'Echo 3**
**1213 Onex, Geneva (CH)**

(54) **THERMOELECTRIC CONVERSION MODULE, THERMOELECTRIC CONVERSION DEVICE, POWER GENERATION METHOD, AND HEAT TRANSMISSION METHOD**

(57)  A thermoelectric conversion module (18) includes: a substrate (40); and a plurality of thermoelectric converters (42) arranged on the substrate (40). Each of the plurality of thermoelectric converters (42) includes: an N-type thermoelectric conversion element (44) having a first cross-sectional area in a cross-sectional view; a P-type thermoelectric conversion element (46) having a second cross-sectional area in the cross-sectional view, where the second cross-sectional area is smaller than the first cross-sectional area; and an electrode (48) that electrically connects one end portion of the N-type thermoelectric conversion element (44) to one end portion of the P-type thermoelectric conversion element (46). At least one of a first condition expressed by $\tau_{1\alpha} > \tau_{1\beta}$ or a second condition expressed by $\tau_{2\alpha} > \tau_{2\beta}$ is satisfied.

FIG. 4

**Description**

[Technical Field]

The present disclosure relates to a thermoelectric conversion module, a thermoelectric conversion device, a power generation method, and a heat conduction method.

[Background Art]

A thermoelectric conversion module used for thermoelectric power generation that uses Seebeck effect or used for thermoelectric cooling that uses Peltier effect is known. This thermoelectric conversion module includes: an N-type thermoelectric conversion element; a P-type thermoelectric conversion element; and an electrode that electrically connects one end portion of the N-type thermoelectric conversion element to one end portion of the P-type thermoelectric conversion element.

Energy conversion efficiency between heat and electricity (hereinafter referred to as "thermoelectric conversion efficiency") in thermoelectric power generation or thermoelectric cooling is determined by the figures of merit of materials for forming an N-type thermoelectric conversion element and a P-type thermoelectric conversion element. In other words, the thermoelectric conversion efficiency increases as the figures of merit increase. PTL 1 and NPL 1 disclose techniques of using a $Mg_3Sb_2$ compound that indicates high figure of merit as the material of an N-type thermoelectric conversion element.

[Citation List]

[Patent Literature]

[PTL 1] Japanese Patent No. 6127281
[PTL 2] Japanese Unexamined Patent Application Publication No. 2013-012571

[Non Patent Literature]

[NPL 1] H. Tamaki et al., Advanced Materials 28, 10182, (2016).
[NPL 2] R. Shu et al., Adv. Funct, Mater. 29, 1807235 (2019).
[NPL 3] G. Li et al., J. Mater. Chem. A, 5, 9050 (2017).
[NPL 4] G. Li et al., Phys. Rev. Lett. 119, 085501 (2017).

[Summary of Invention]

[Technical Problem]

The present disclosure provides a thermoelectric conversion module that can increase the strength of the thermoelectric conversion module while increasing thermoelectric conversion efficiency, a thermoelectric conversion device, a heat generation method, and a heat conduction method.

[Solution to Problem]

A thermoelectric conversion module according to one aspect of the present disclosure includes: a substrate including a principal surface; and a plurality of thermoelectric converters arranged on the principal surface of the substrate. Each of the plurality of thermoelectric converters includes: a first thermoelectric conversion element having a first cross-sectional area in a cross-sectional view in a plane approximately parallel to the principal surface; a second thermoelectric conversion element having a second cross-sectional area in the cross-sectional view, where the second cross-sectional area is smaller than the first cross-sectional area; and an electrode that electrically connects one end portion of the first thermoelectric conversion element to one end portion of the second thermoelectric conversion element. At least one of a first condition expressed by $\tau_{1\alpha} > \tau_{1\beta}$ or a second condition expressed by $\tau_{2\alpha} > \tau_{2\beta}$ is satisfied. In the first condition: $\tau_{1\alpha}$ denotes compressive stress applied to the first thermoelectric conversion element for generating compressive strain $\varepsilon_1$ in

the thermoelectric conversion module; and $\tau_{1\beta}$ denotes compressive stress applied to the second thermoelectric conversion element for generating the compressive strain $\varepsilon_1$ in the thermoelectric conversion module. In the second condition: $\tau_{2\alpha}$ denotes shear stress applied to the first thermoelectric conversion element for generating shear strain $\varepsilon_2$ in the thermoelectric conversion module; and $\tau_{2\beta}$ denotes shear stress applied to the second thermoelectric conversion element for generating the shear strain $\varepsilon_2$ in the thermoelectric conversion module.

Note that these general or specific aspects may be realized by devices, methods, or any combination thereof.

[Advantageous Effects of Invention]

With the thermoelectric conversion module according to one aspect of the present disclosure, it is possible to increase the strength of the thermoelectric conversion module while increasing thermoelectric conversion efficiency.

[Brief Description of Drawings]

[FIG. 1]

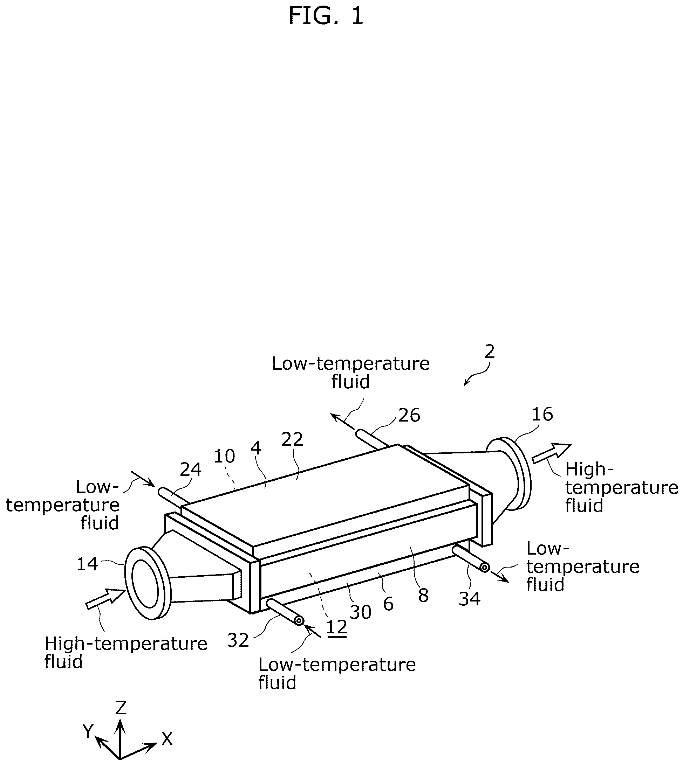

FIG. 1 is a perspective view illustrating a thermoelectric conversion device according to an embodiment.
[FIG. 2]

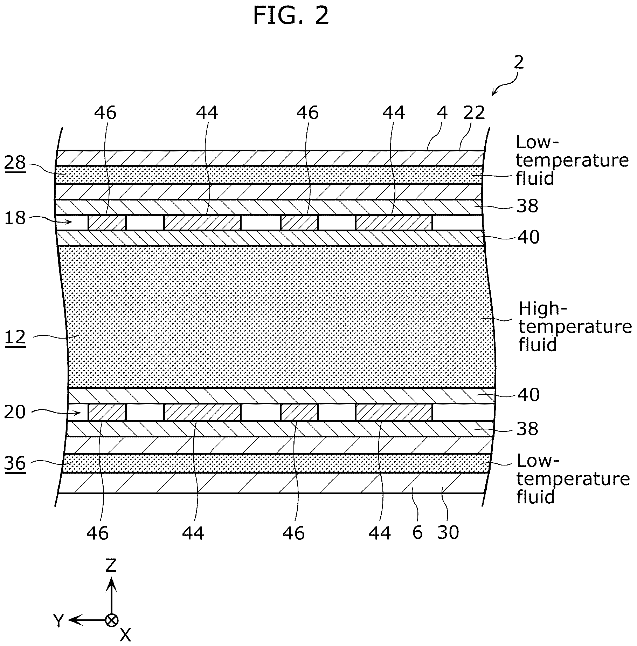

FIG. 2 is a cross-sectional view illustrating important parts of the thermoelectric conversion device according to the embodiment.
[FIG. 3]

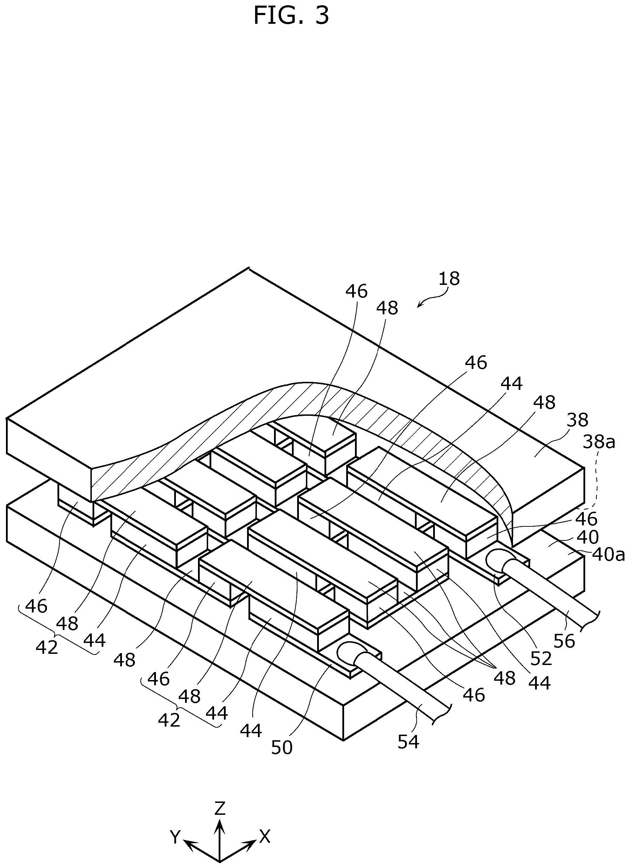

FIG. 3 is a perspective view illustrating a thermoelectric conversion module according to the embodiment.
[FIG. 4]

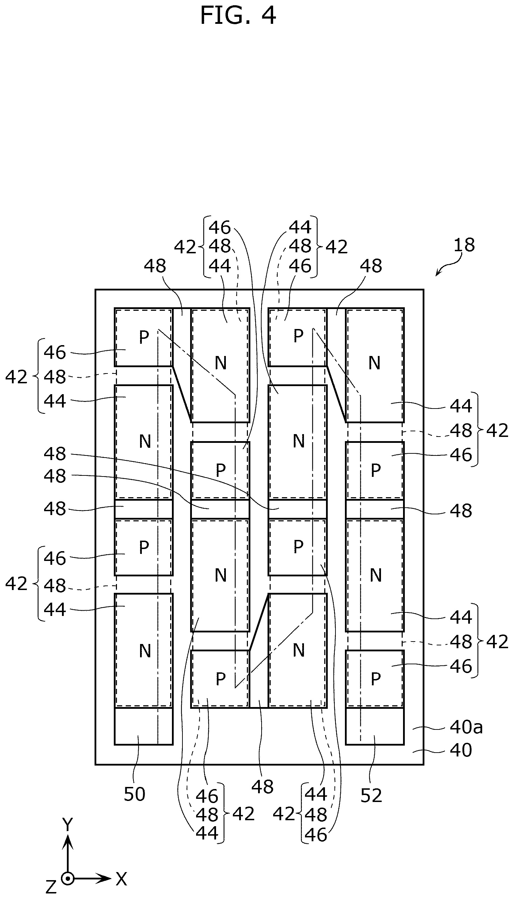

FIG. 4 is a plan view illustrating the thermoelectric conversion module according to the embodiment, from which one substrate is omitted.
[FIG. 5]

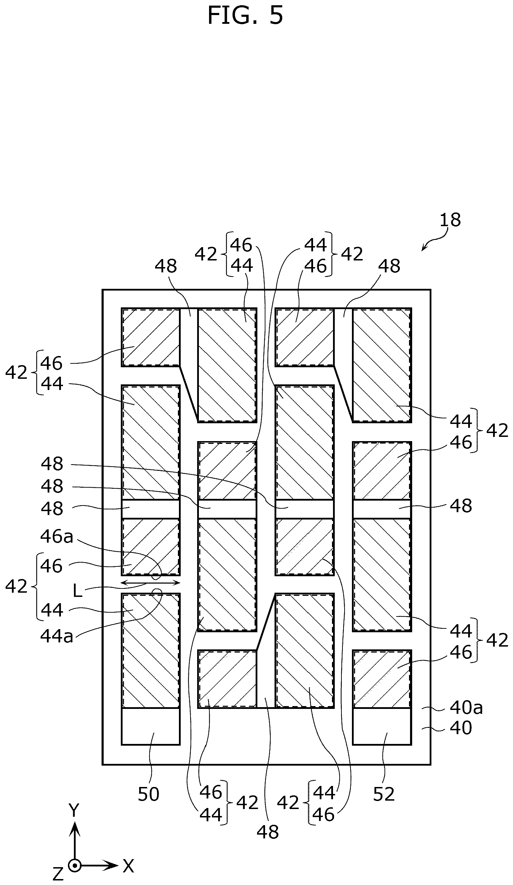

FIG. 5 is a cross-sectional view of the thermoelectric conversion module according to the embodiment.
[FIG. 6]

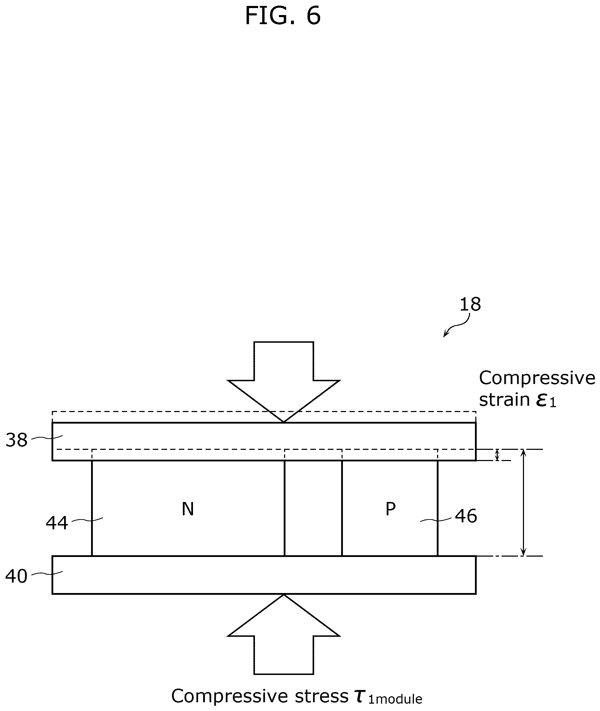

FIG. 6 is a diagram for illustrating compressive stress that works on the thermoelectric conversion module according to the embodiment.
[FIG. 7]

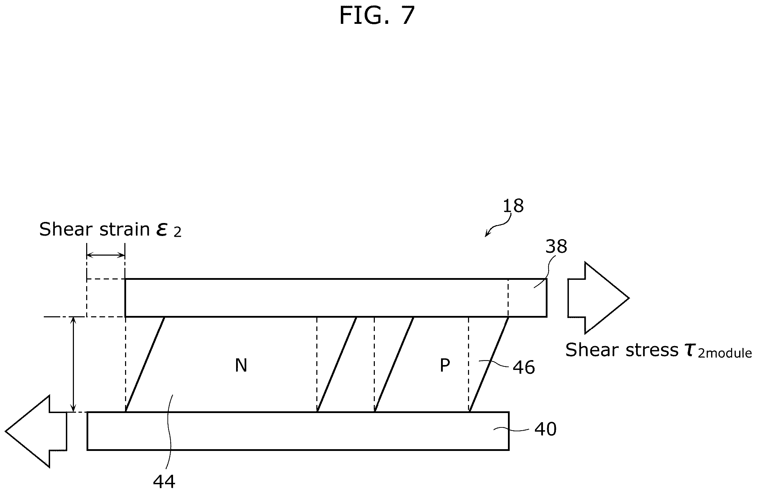

FIG. 7 is a diagram for illustrating shear stress that works on the thermoelectric conversion module according to the embodiment.
[FIG. 8]

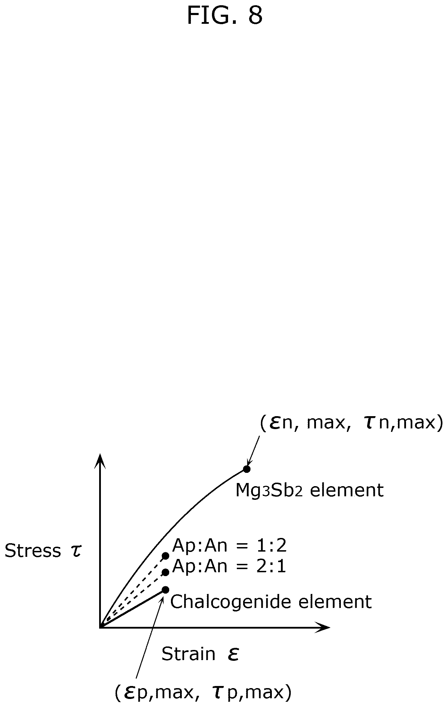

FIG. 8 is a graph illustrating a relationship between strain and stress in the thermoelectric conversion module according to the embodiment.
[FIG. 9]

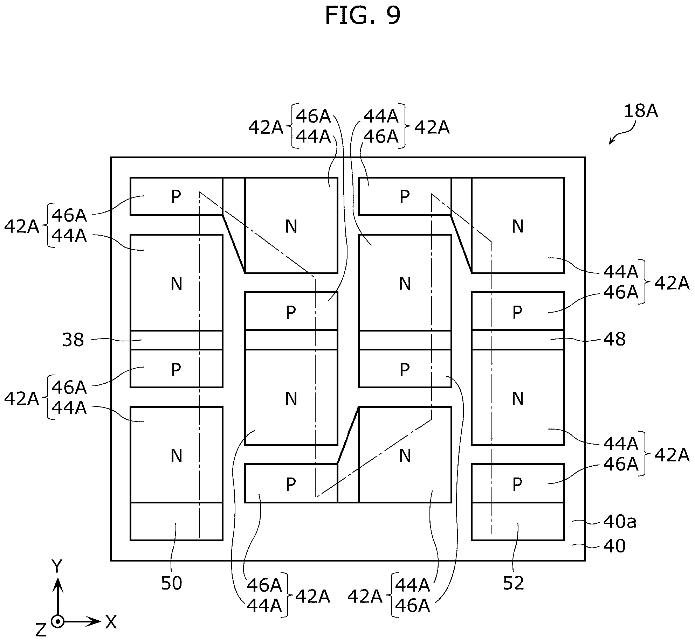

FIG. 9 is a plan view illustrating a thermoelectric conversion module according to Variation 1 of the embodiment, from which one substrate is omitted.
[FIG. 10]

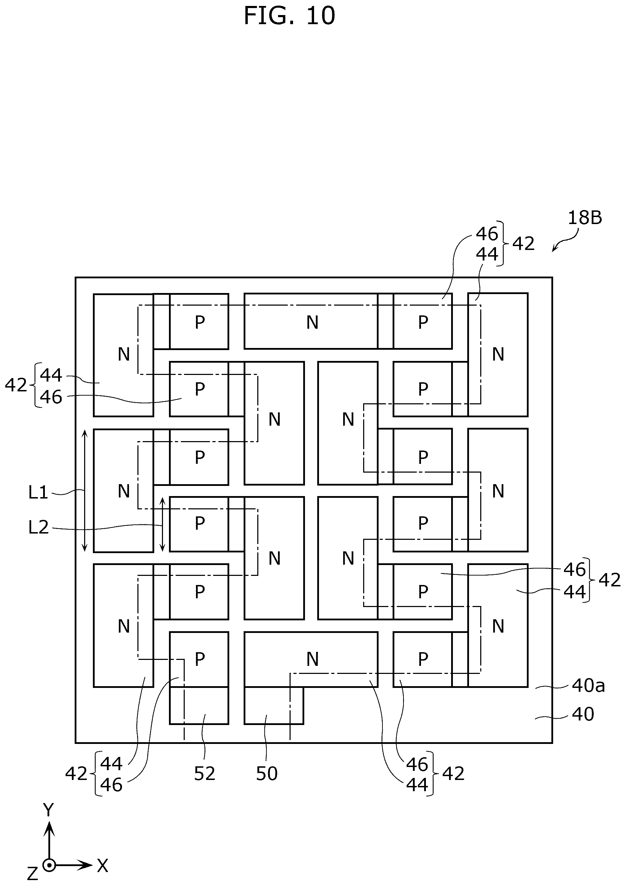

FIG. 10 is a plan view illustrating a thermoelectric conversion module according to Variation 2 of the embodiment, from which one substrate is omitted.
[FIG. 11]

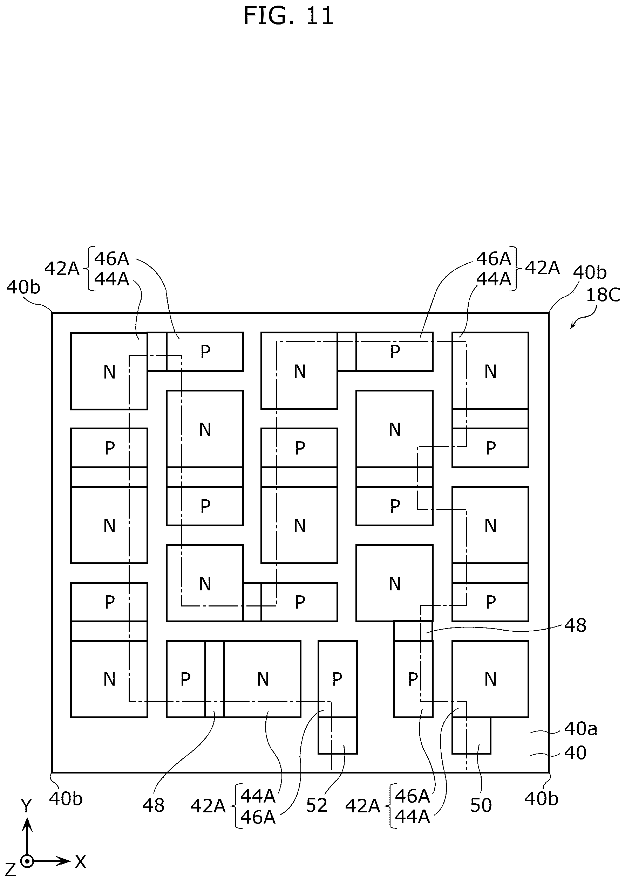

FIG. 11 is a plan view illustrating a thermoelectric conversion module according to Variation 3 of the embodiment, from which one substrate is omitted.
[FIG. 12]

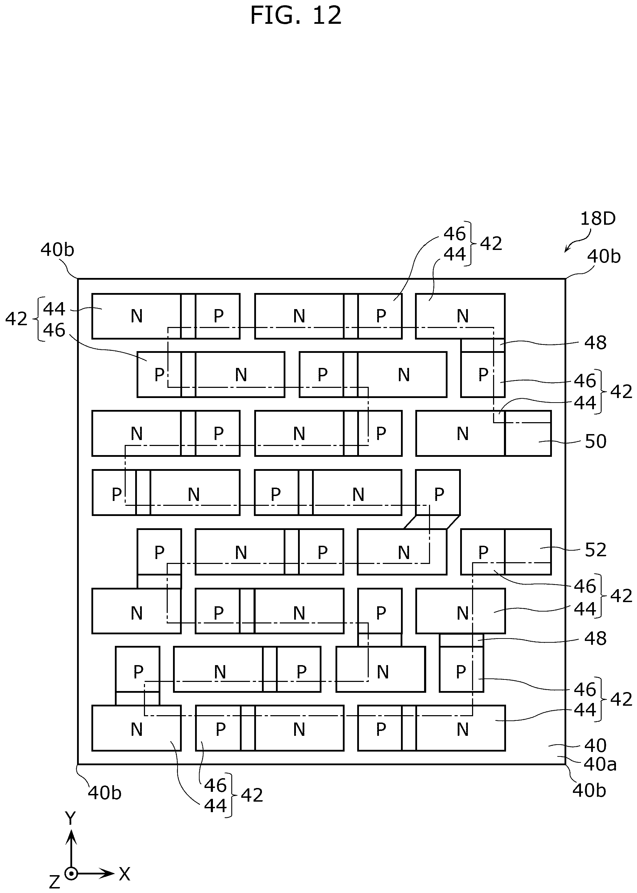

FIG. 12 is a plan view illustrating a thermoelectric conversion module according to Variation 4 of the embodiment, from which one substrate is omitted.

[Description of Embodiments]

(Underlying Knowledge Forming Basis of the Present Disclosure)

The inventors have discovered the following problems related to the techniques mentioned in the "Background Art" section.
Thermoelectric power generation is a technique of converting thermal energy into electrical energy by using Seebeck effect, i.e., thermoelectromotive force generated between ends of an object in proportion to a temperature difference when the temperature difference is generated between the ends of the object. Thermoelectric cooling is a technique that uses Peltier effect, i.e., a phenomenon that heat is transferred by electrons carried by electric current. Thermoelectric power generation is put into practice as, for example, power supply for remote areas and power sources for outer space applications, whereas thermoelectric cooling is put into practice as, for example, an element for performing precision temperature control on, for instance, electronic devices and optical devices.

Energy conversion efficiency between heat and electricity in thermoelectric power generation or thermoelectric cooling is determined by figure of merit ZT of a material to be used. The energy conversion efficiency increases as figure of merit ZT increases, and high figure of merit ZT is realized in a semiconductor in which electrical conduction carriers have been injected.

A thermoelectric conversion module of a type having a $\pi$-type structure is known. In this type of thermoelectric conversion module, a P-type thermoelectric conversion element and an N-type thermoelectric conversion element, which have Seebeck coefficients S having different codes, are electrically connected in series and disposed parallel to a heat flow. With this, effective thermoelectric conversion is achieved. In a thermoelectric conversion module having a practical $\pi$-type structure, tolerance against stress generated by increasing pressure or thermal stress caused by a temperature difference is significant. In other words, it is important to increase the strength of the entire thermoelectric conversion module. For this reason, in addition to the sufficient mechanical strength of the P-type thermoelectric conversion element and the N-type thermoelectric conversion element on a substrate, the arrangement of the P-type thermoelectric conversion element and the N-type thermoelectric conversion element on the substrate is important.

A chalcogenide compound as represented by a $Bi_2Te_3$ ($Sb_2Te_3$) compound or a GeTe compound is known as a thermoelectric conversion material that indicates high figure of merit. Since the chalcogenide compound uses tellurium (Te) and selenium (Se) that are rare elements and is a fragile material, the chalcogenide compound should be handled with care.

An N-type $Mg_3Sb_2$ compound as disclosed in PTL 1 and NPL 1 is known as a thermoelectric conversion material which indicates high figure of merit and includes small amounts of rare metals.

However, when a $Mg_3Sb_2$ compound is used as the material of the N-type thermoelectric conversion element, there rises a problem that the strength of the thermoelectric conversion module decreases depending on the material of the P-type thermoelectric conversion element.

The inventors have paid attention to a thermoelectric conversion module which (i) includes, as a pair, an N-type thermoelectric conversion element that includes a $Mg_3Sb_2$ compound and a P-type thermoelectric conversion element that includes a chalcogenide compound, and (ii) can be used as a thermoelectric conversion module or a Pertier cooling module that has high figure of merit. The inventors have also discovered increasing the cross-sectional area of the N-type thermoelectric conversion element to be larger than the cross-sectional area of the P-type thermoelectric conversion element. With this, a decrease in the usage amount of rare metals and tolerance enhancement in the entire thermoelectric conversion module are expected.

PTL 2 discloses a thermoelectric conversion module that uses an N-type thermoelectric conversion element and a P-type thermoelectric conversion element that have different cross-sectional areas. More specifically, PTL 2 discloses a thermoelectric conversion module including an N-type thermoelectric conversion element and a P-type thermoelectric conversion element having different cross-sectional areas to suppress a decrease in output by the thermoelectric conversion module due to an increase in connection resistance, but neither discloses nor suggests forming an N-type thermoelectric conversion element using a $Mg_3Sb_2$ compound and forming a P-type thermoelectric conversion element using a chalcogenide compound.

Moreover, the inventors have repeated earnest consideration and newly discovered that by arranging an N-type thermoelectric conversion element and a P-type thermoelectric conversion element so that the length of one side of an N-type thermoelectric conversion element and the length of one side of a P-type thermoelectric conversion element are approximately same and one side of the N-type thermoelectric conversion element and one side of the P-type thermoelectric conversion element face each other in cross-sectional view, an effect of increasing the strength of the entire thermoelectric conversion module can be obtained. PTL 2 neither discloses nor suggests such an arrangement of the thermoelectric conversion elements for increasing the strength of the entire thermoelectric conversion module.

Based on this new knowledge, the inventors have completed the thermoelectric conversion module according to the present disclosure.

A thermoelectric conversion module according to a first aspect of the present disclosure includes: a substrate including a principal surface; and a plurality of thermoelectric converters arranged on the principal surface of the substrate. Each of the plurality of thermoelectric converters includes: a first thermoelectric conversion element having a first cross-sectional area in a cross-sectional view in a plane approximately parallel to the principal surface; a second thermoelectric conversion element having a second cross-sectional area in the cross-sectional view, where the second cross-sectional area is smaller than the first cross-sectional area; and an electrode that electrically connects one end portion of the first thermoelectric conversion element to one end portion of the second thermoelectric conversion element. At least one of a first condition expressed by $\tau_{1\alpha} > \tau_{1\beta}$ or a second condition expressed by $\tau_{2\alpha} > \tau_{2\beta}$ is satisfied. In the first condition: $\tau_{1\alpha}$

denotes compressive stress applied to the first thermoelectric conversion element for generating compressive strain $\varepsilon_1$ in the thermoelectric conversion module; and $\tau_{1\beta}$ denotes compressive stress applied to the second thermoelectric conversion element for generating the compressive strain $\varepsilon_1$ in the thermoelectric conversion module. In the second condition: $\tau_{2\alpha}$ denotes shear stress applied to the first thermoelectric conversion element for generating shear strain $\varepsilon_2$ in the thermoelectric conversion module; and $\tau_{2\beta}$ denotes shear stress applied to the second thermoelectric conversion element for generating the shear strain $\varepsilon_2$ in the thermoelectric conversion module.

According to the present aspect, a thermoelectric conversion module that is strong against compressive stress or shear stress can be achieved.

With the thermoelectric conversion module according to a second aspect of the present disclosure, in the first aspect, the first thermoelectric conversion element may be an N-type thermoelectric conversion element, and the second thermoelectric conversion element may be a P-type thermoelectric conversion element.

The thermoelectric conversion module according to a third aspect of the present disclosure includes: a substrate including a principal surface; and a plurality of thermoelectric converters arranged on the principal surface of the substrate. Each of the plurality of thermoelectric converters includes: an N-type thermoelectric conversion element formed into an approximately rectangular shape and having a first cross-sectional area in a cross-sectional view in a plane approximately parallel to the principal surface; a P-type thermoelectric conversion element formed into an approximately rectangular shape and having a second cross-sectional area in the cross-sectional view, where the second cross-sectional area is smaller than the first cross-sectional area; and an electrode that electrically connects one end portion of the N-type thermoelectric conversion element to one end portion of the P-type thermoelectric conversion element. The N-type thermoelectric conversion element contains Mg. Specific thermoelectric converters, among the plurality of thermoelectric converters, are disposed such that a first side of the N-type thermoelectric conversion element and a second side of the P-type thermoelectric conversion element face each other in the cross-sectional view, where the first side has an approximately same length as the second side.

According to the present aspect, since the N-type thermoelectric conversion element contains Mg, the figure of merit and strength of the N-type thermoelectric conversion element can be increased. By increasing the first cross-sectional area of the N-type thermoelectric conversion element having such relatively high figure of merit and strength to be greater than the second cross-sectional area of the P-type thermoelectric conversion element, the strength of the thermoelectric conversion module can be increased while increasing thermoelectric conversion efficiency.

With the thermoelectric conversion module according to a fourth aspect of the present disclosure, in any one of the first to third aspects, the first cross-sectional area may be at least 1.5 times and at most 4 times the second cross-sectional area.

According to the present aspect, the strength of the thermoelectric conversion module can be effectively increased while effectively increasing thermoelectric conversion efficiency.

With the thermoelectric conversion module according to a fifth aspect of the present disclosure, in the third aspect, the specific thermoelectric converters may be disposed at least in the peripheral region of the substrate. The peripheral region may be a region in which the N-type thermoelectric conversion element and the P-type thermoelectric conversion element are disposed along the periphery of the substrate, where the N-type thermoelectric conversion element and the P-type thermoelectric conversion element are among the N-type thermoelectric conversion elements and the P-type thermoelectric conversion elements arranged on the principal surface of the substrate.

When the thermoelectric conversion module according to the present aspect is used in a thermoelectric conversion device, pressure or vibrations are likely to work in the peripheral region of the substrate. By disposing specific thermoelectric converters in such a peripheral region of the substrate, the strength of the thermoelectric conversion module can be effectively increased.

With the thermoelectric conversion module according to a sixth aspect of the present disclosure, in the fifth aspect, two or more specific thermoelectric converters may be electrically connected in series in a first direction and may be arranged adjacent to each other in a second direction orthogonal to the first direction, where the two or more specific thermoelectric converters are the specific thermoelectric converters.

According to the present aspect, it is possible to arrange a plurality of N-type thermoelectric conversion elements and a plurality of P-type thermoelectric conversion elements with high density.

With the thermoelectric conversion module according to a seventh aspect of the present disclosure, in the second or fifth aspect, the substrate may be of a polygonal shape including vertexes, and each of the N-type thermoelectric conversion elements may be disposed in a position closest to a corresponding one of the vertexes on the principal surface of the substrate.

According to the present aspect, when the thermoelectric conversion module is used in a thermoelectric conversion device, pressure or vibrations are likely to work in the vicinity of each of vertexes of the substrate. By disposing an N-type thermoelectric conversion element in such a vicinity of a corresponding one of the vertexes of the substrate, the strength of the thermoelectric conversion module can be effectively increased.

With the thermoelectric conversion module according to an eighth aspect of the present disclosure, in the second or fifth aspect, in the cross-sectional view, the length of a longer side of each of the N-type thermoelectric conversion elements may be at least two times the length of any one side of each of the P-type thermoelectric conversion elements.

According to the present aspect, it is possible to arrange a plurality of N-type thermoelectric conversion elements and a plurality of P-type thermoelectric conversion elements with high density.

With the thermoelectric conversion module according to a ninth aspect of the present disclosure, in the fifth or sixth aspect, the total number of the N-type thermoelectric conversion elements arranged in the peripheral region may be greater than the total number of the P-type thermoelectric conversion elements arranged in the peripheral region.

According to the present aspect, the strength of the thermoelectric conversion module in the peripheral region of the substrate can be increased.

With the thermoelectric conversion module according to a tenth aspect of the present disclosure, in the second aspect, compressive fracture stress $\tau_{1n,max}$ of the N-type thermoelectric conversion element may be greater than compressive fracture stress $\tau_{1p,max}$ of the P-type thermoelectric conversion element, or shear fracture stress $\tau_{2n,max}$ of the N-type thermoelectric conversion element may be greater than shear fracture stress $\tau_{2p,max}$ of the P-type thermoelectric conversion element.

According to the present aspect, it is possible to increase the strength of the N-type thermoelectric conversion element against compressive stress or shear stress, as compared with the strength of the P-type thermoelectric conversion element.

With the thermoelectric conversion module according to an eleventh aspect of the present disclosure, in the second aspect, a third condition expressed by $2 \leq \sigma_p / \sigma_n \leq 4$ may be satisfied. In the third condition: $\sigma_n$ may denote the electrical conductivity of the N-type thermoelectric conversion element at a room temperature; and $\sigma_p$ may denote the electrical conductivity of the P-type thermoelectric conversion element at a room temperature.

According to the present aspect, by changing the composition of each of the P-type thermoelectric conversion element and the N-type thermoelectric conversion element where necessary, it is possible to control the degree of carrier density and the degree of carrier mobility of each of the P-type thermoelectric conversion element and the N-type thermoelectric conversion element to change the electrical conductivity of each of the P-type thermoelectric conversion element and the N-type thermoelectric conversion element. As a result, it is possible to overcome unbalance in electrical properties between the N-type thermoelectric conversion element and the P-type thermoelectric conversion element caused by increasing the first cross-sectional area of the N-type thermoelectrical conversion element to be greater than the second cross-sectional area of the P-type thermoelectric conversion element, and thereby effectively increasing thermoelectric conversion efficiency. In the case of a $Bi_2Te_3$ compound, a carrier density, carrier mobility, and electrical conductivity change according to the mutual ratio of Bi, Sb, Te, and Se, or adjustment in the additive amount of, for instance, Cu, Sn, and I. In the case of a $Mg_3Sb_2$ compound, a carrier density, carrier mobility, and electrical conductivity change according to the mutual ratio of Mg, Sb, and Bi, or adjustment in the additive amount of, for instance, Mn, Zn, Li, Na, K, Sc, Y, La, B, Al, Ge, Sn, Pb, Se, and Te.

With the thermoelectric conversion module according to a twelfth aspect of the present disclosure, in the eleventh aspect, $\sigma_p$ may satisfy a condition expressed by 400 S/cm $\leq \sigma_p \leq$ 4000 S/cm.

According to the present aspect, by changing the composition of the P-type thermoelectric conversion element where necessary, it is possible to perform control to increase the carrier density of the P-type thermoelectric conversion element to change the electrical conductivity of the P-type thermoelectric conversion element.

With the thermoelectric conversion module according to a thirteenth aspect of the present disclosure, in the eleventh or twelfth aspect, $\sigma_n$ may satisfy a condition expressed by 100 S/cm $\leq \sigma_n \leq$ 1000 S/cm.

According to the present aspect, by changing the composition of the N-type thermoelectric conversion element where necessary, it is possible to perform control to suppress the carrier density of the N-type thermoelectric conversion element to change the electrical conductivity of the N-type thermoelectric conversion element.

With the thermoelectric conversion module according to a fourteenth aspect of the present disclosure, in any one of the second to thirteenth aspects, the P-type thermoelectric conversion element may include a chalcogenide compound.

According to the present aspect, the figure of merit of the P-type thermoelectric conversion element can be increased. This enables effectively increasing thermoelectric conversion efficiency.

With the thermoelectric conversion module according to a fifteenth aspect of the present disclosure, in the fourteenth aspect, the P-type thermoelectric conversion element may include a $(Bi, Sb)_2(Se, Te)_3$ compound or a $(Ge, Sn, Pb)_a(Sb, Bi)_b(Mg, Mn, Ti, In, Cr, Ag, Zn)_c(S, Se, Te)$ compound.

According to the present aspect, the figure of merit and strength of the P-type thermoelectric conversion element can be increased. This enables effectively increasing thermoelectric conversion efficiency.

With the thermoelectric conversion module according to a sixteenth aspect of the present disclosure, in any one of the second to fifteenth aspects, the N-type thermoelectric conversion element may further contain at least one of Sb or Bi.

According to the present aspect, the figure of merit and strength of the N-type thermoelectric conversion element can be increased. This enables increasing the strength of the thermoelectric conversion module while increasing thermoelectric conversion efficiency.

With the thermoelectric conversion module according to a seventeenth aspect of the present disclosure, in the sixteenth aspect, the N-type thermoelectric conversion element may include a $Mg_3(Sb, Bi)_2$ compound.

According to the present aspect, the figure of merit and strength of the N-type thermoelectric conversion element can be increased. This enables increasing the strength of the thermoelectric conversion module while increasing thermoelectric conversion efficiency.

A thermoelectric conversion device according to an eighteenth aspect of the present disclosure includes: a first fluid flow path along which a first fluid flows; a second fluid flow path along which a second fluid flows; and the thermoelectric conversion module according to any one of the first to seventeenth aspects that converts thermal energy generated by a temperature difference between the first fluid and the second fluid into electric power.

According to the present aspect, by using any one of the thermoelectric conversion modules described above, the strength of the entire thermoelectric conversion module can be increased while increasing thermoelectric conversion efficiency.

A power generation method according to a nineteenth aspect of the present disclosure includes: giving a temperature difference to the thermoelectric conversion module according to any one of the first to seventeenth aspects; and extracting electric power based on thermoelectromotive force generated in each of the plurality of thermoelectric converters in the thermoelectric conversion module due to the temperature difference.

According to the present aspect, by using any one of the thermoelectric conversion modules described above, thermoelectric power generation can be effectively performed.

A heat conduction method according to a twentieth aspect of the present disclosure includes: allowing current to flow through the thermoelectric conversion module according to any one of the first to seventeenth aspects; and transferring heat by the current.

According to the present aspect, by using any one of the thermoelectric conversion modules described above, it is possible to perform precise temperature control by heating or cooling.

Note that these general or specific aspects may be achieved by devices, methods, or any combination thereof.

Hereinafter, an embodiment of the present disclosure will be described with reference to the drawings.

The embodiment described below illustrates a general or specific example of the present disclosure. The numerical values, shapes, materials, elements, the arrangement positions and connections of the elements, steps, order of the steps, etc., shown in the following embodiment are mere examples, and therefore do not intend to limit the scope of claims. Among elements in the following embodiments, elements not described in independent claims reciting the broadest concept are illustrated as optional elements. The figures are schematic diagrams and are not necessarily precise illustrations. Elements that are essentially the same share like reference signs in the figures, and duplicate description is omitted or simplified.

[Embodiment]

[1. Outline of Thermoelectric Conversion Device]

First, the outline of thermoelectric conversion device 2 according to an embodiment will be described with reference to FIG. 1 and FIG. 2. FIG. 1 is a perspective view of thermoelectric conversion device 2 according to the embodiment. FIG. 2 is a cross-sectional view illustrating important parts of thermoelectric conversion device 2 according to the embodiment.

In FIG. 1 and FIG. 2, the front-rear direction of thermoelectric conversion device 2 is defined as an X-axis direction, the left-right direction of thermoelectric conversion device 2 is defined as a Y-axis direction, and the up-down direction of thermoelectric conversion device 2 is defined as a Z-axis direction.

Thermoelectric conversion device 2 is, for example, a thermoelectric conversion unit for generating power using thermal energy of exhaust gas exhausted from an engine provided in a vehicle.

As illustrated in FIG. 1 and FIG. 2, thermoelectric conversion device 2 includes a pair of low-temperature fluid flow paths 4, 6 (one example of a first fluid flow path), a pair of lateral-face binders 8, 10, a high-temperature flow path 12 (one example of a second fluid flow path), high-temperature fluid entrance 14, high-temperature fluid exit 16, and a pair of thermoelectric conversion modules 18, 20.

Low-temperature fluid flow paths 4 and 6 in pair are disposed opposed to each other with a space therebetween in the up-down direction (Z-axis direction).

Low-temperature fluid flow path 4 on the upper side includes case 22 that is a flat and empty cuboid, and low-temperature fluid entrance 24 and low-temperature fluid exit 26 each of which is cylindrical and protrudes outward from the lateral face of case 22. Case 22 is made of, for example, stainless steel or the like. As illustrated in FIG. 2, low-temperature fluid flow path 28 along which a low-temperature fluid (one example of a first fluid) flows is formed inside case 22. The low-temperature fluid is, for example, cold water or a cold wind whose temperature is lower than the temperature of a high-temperature fluid (to be described later). Low-temperature fluid entrance 24 and low-temperature fluid exit 26 are disposed in the front-rear direction (the X-axis direction) with a space therebetween, and communicate with low-temperature fluid flow path 28 of case 22. A low-temperature fluid flows into low-temperature fluid flow path 28 of case 22 through low-temperature fluid entrance 24, and is exhausted to outside through low-temperature fluid exit 26 after flowing through low-temperature fluid flow path 28.

Low-temperature fluid flow path 6 on the lower side includes case 30 that is a flat and empty cuboid, and low-temperature fluid entrance 32 and low-temperature fluid exit 34 each of which is cylindrical and protrudes outward from the lateral face of case 30. Case 30 is made of, for example, stainless steel or the like. As illustrated in FIG. 2, low-temperature fluid flow path 36 along which a low-temperature fluid flows is formed inside case 30. Low-temperature fluid entrance 32 and low-temperature fluid exit 36 are disposed in the front-rear direction with a space therebetween and communicate with low-temperature fluid flow path 36 of case 30. A low-temperature fluid flows into low-temperature fluid flow path 36 of case 30 through low-temperature fluid entrance 32, and is exhausted to outside through low-temperature fluid exit 34 after flowing through low-temperature fluid flow path 36.

As illustrated in FIG. 1, a pair of lateral-face binders 8, 10 is disposed facing each other in the right-left direction (the Y-axis direction) with a space therebetween. In other words, a pair of lateral-face binders 8, 10 is disposed to cover, from the lateral sides in the right-left direction, high-temperature fluid flow path 12 (to be described later) interposed between the pair of low-temperature fluid flow paths 4, 6. Each of lateral-face binders 8, 10 in pair is formed into a rectangular and planar shape.

As illustrated in FIG. 2, high-temperature fluid flow path 12 is interposed between low-temperature fluid flow paths 4, 6 in pair. Specifically, high-temperature fluid flow path 12 is defined by a space surrounded by the pair of low-temperature fluid flow paths 4, 6, and the pair of lateral-face binders 8, 10. High-temperature fluid flow path 12 functions as a high-temperature fluid flow path along which a high-temperature fluid (one example of a second fluid) flows. The high-temperature fluid is a fluid with a temperature higher than a low-temperature fluid, and is, for example, exhaust gas or the like exhausted from an engine provided in a vehicle. A plurality of heat conduction fins are arranged in high-temperature fluid flow path 12 for transferring heat of the high-temperature fluid to each of a pair of thermoelectric conversion modules 18, 20, although not shown in the figure.

High-temperature fluid entrance 14 and high-temperature fluid exit 16 are disposed opposed to each other with a space interposed therebetween in the front-rear direction. In other words, high-temperature fluid entrance 14 and high-temperature fluid exit 16 are disposed to cover high-temperature fluid flow path 12 interposed between low-temperature fluid flow paths 4, 6 in pair from the lateral side of the front-rear direction. High-temperature fluid entrance 14 and high-temperature fluid exit 16 are each formed into a cylindrical shape, and communicate with high-temperature fluid flow path 12. A high fluid flows into high-temperature fluid flow path 12 through high-temperature fluid entrance 14, and is exhausted to outside through high-temperature fluid exit 16 after flowing through high-temperature fluid flow path 12 in the front-rear direction (from the X-axis negative side to the X-axis positive side).

As illustrated in FIG. 2, thermoelectric conversion modules 18, 20 in pair are disposed between high-temperature fluid flow path 12 and low-temperature fluid flow path 4 and between high-temperature flow path 12 and low-temperature fluid flow path 6, respectively. In other words, thermoelectric conversion modules 18, 20 in pair are disposed opposed to each other with a space therebetween in the up-down direction.

Thermoelectric conversion module 18 on the upper side is formed into a rectangular flat-plate shape as a whole, and is disposed sandwiched, in the up-down direction, between high-temperature fluid flow path 12 and low-temperature fluid flow path 4 on the upper side. In other words, thermoelectric conversion module 18 on the upper side contacts the lower face of case 22 of low-temperature fluid flow path 4 on the upper side (the face on the high-temperature fluid flow path 12 side), and also contacts, for instance, a heat conduction fin of high-temperature fluid flow path 12. With this, owing to Seebeck effect, thermoelectric conversion module 18 on the upper side performs thermoelectric power generation of converting thermal energy generated by a temperature difference between a high-temperature fluid flowing through high-temperature fluid flow path 12 and a low-temperature fluid flowing through low-temperature fluid flow path 4 on the upper side.

Thermoelectric conversion module 20 on the lower side is formed into a rectangular flat-plate shape as a whole, and is disposed sandwiched, in the up-down direction, between high-temperature fluid flow path 12 and low-temperature fluid flow path 6 on the lower side. In other words, thermoelectric conversion module 20 on the lower side contacts the upper face of case 30 of low-temperature fluid flow path 6 on the lower side (the face on the high-temperature fluid flow path 12 side), and also contacts, for instance, a heat conduction fin of high-temperature fluid flow path 12. With this, owing to Seebeck effect, thermoelectric conversion module 20 on the lower side performs thermoelectric power generation of converting thermal energy generated by a temperature difference between a high-temperature fluid flowing through high-temperature fluid flow path 12 and a low-temperature fluid flowing through low-temperature fluid flow path 6 on the lower side.

[2. Configuration of Thermoelectric Conversion Module]

The configuration of thermoelectric conversion module 18 will be described with reference to FIG. 2 to FIG. 5. Since each of thermoelectric conversion modules 18, 20 in pair has the same configuration, the following describes only the configuration of thermoelectric conversion module 18.

FIG. 3 is a perspective view illustrating thermoelectric conversion module 18 according to the embodiment. FIG. 4 is a plan view illustrating thermoelectric conversion module 18, from which one substrate 38 is omitted. FIG. 5 is a cross-sectional view of thermoelectric conversion module 18 according to the embodiment.

In FIG. 3 to FIG. 5, the lateral direction of thermoelectric conversion module 18 is defined as the X-axis direction, the vertical direction of thermoelectric conversion module 18 is defined as the Y-axis direction, and the thickness direction of thermoelectric conversion module 18 is defined as the Z-axis direction.

As illustrated in FIG. 3, thermoelectric conversion module 18 includes a pair of substrates 38, 40 and a plurality of thermoelectric converters 42. Thermoelectric conversion module 18 has a $\pi$-type structure. By giving a temperature difference to thermoelectric conversion module 18, it is possible to extract thermoelectromotive force generated by a temperature difference in each of the plurality of thermoelectric converters 42 in thermoelectric conversion module 18.

Each of substrates 38, 40 in pair is formed into a rectangular (one example of a polygonal shape having vertexes) flat-plate shape, and is formed of a ceramic substrate. Substrates 38, 40 in pair are disposed opposed to each other in the thickness direction (the Z-axis direction) of thermoelectric conversion module 18. As illustrated in FIG. 2, one substrate 38 contacts the lower surface of case 22 of low-temperature fluid flow path 4 on the upper side, and other substrate 40 contacts high-temperature fluid flow path 12. In this case, one substrate 38 comes into close contact with case 22 of lower-temperature fluid flow path 4 on the upper side while pressure is added thereto, in order to reduce contact thermal resistance between one substrate 38 and case 22 of low-temperature fluid flow path 4 on the upper side. In addition, to decrease contact thermal resistance between other substrate 40 and high-temperature fluid flow path 12, other substrate 40 comes into close contact with high-temperature fluid flow path 12 while pressure is added thereto. In FIG. 3, a part of one substrate 38 is cut out for the sake of convenience in illustration.

The plurality of thermoelectric converters 42 are disposed between substrates 38, 40 in pair. Specifically, the plurality of thermoelectric converters 42 are disposed on principal surfaces 38a and 40a, of substrates 38, 40 in pair, respectively, which face each other. Each of the plurality of thermoelectric converters 42 includes N-type thermoelectric conversion element 44 (one example of a first thermoelectric conversion element), P-type thermoelectric conversion element 46 (one example of a second thermoelectric conversion element), and electrode 48. N-type thermoelectric conversion element 44 and P-type thermoelectric conversion element 46 have Seebeck coefficients whose codes are mutually different.

N-type thermoelectric conversion element 44 is a thermoelectric conversion element whose carrier is an electron, and contains at least one of magnesium (Mg), antimony (Sb), or bismuth (Bi). Specifically, N-type thermoelectric conversion element 44 includes a $Mg_3(Sb, Bi)_2$ compound that indicates high figure of merit. In the present embodiment, N-type thermoelectric conversion element 44 includes, for example, a $Mg_3Sb_2$ compound. In the present specification, (A, B,...) in a chemical formula representing a compound is referred to as at least one of "A" or "B". The $Mg_3(Sb, Bi)_2$ compound is referred to as, for example, a $Mg_3Sb_2$ compound or a $Mg_3Bi_2$ compound.

P-type thermoelectric conversion element 46 is a thermoelectric conversion element whose carrier is a hole and includes a chalcogenide compound. Specifically, P-type thermoelectric conversion element 46 includes a $(Bi, Sb)_2(Se, Te)_3$ compound or a $(Ge, Sn, Pb)_a(Sb, Bi)_b(Mg, Mn, Ti, In, Cr, Ag, Zn)_c(S, Se, Te)$ compound, where a, b, and c are constants. In the present embodiment, P-type thermoelectric conversion element 46 includes, for example, a $Bi_2Te_3$ compound or a GeTe compound.

Electrode 48 is formed into a rectangular flat-plate shape and electrically connects one end portion of N-type thermoelectrical conversion element 44 to one end portion of P-type thermoelectric conversion element 46.

As illustrated in FIG. 4, two thermoelectric converters 42 are electrically connected in series in the Y-axis direction (one example of a first direction), and are arranged adjacent to each other in the X-axis direction (one example of a second direction orthogonal to the first direction). In other words, the two thermoelectric converters are disposed aligned in multiple rows (four rows in the present embodiment) in the X-axis direction. In the present embodiment, two thermoelectric converters 42 are electrically connected in series in the Y-axis direction, but the present disclosure is not limited to this example, and three or more thermoelectric converters 42 may be electrically connected in series in the Y-axis direction.

For example, in FIG. 4, in each of two thermoelectric converters 42 located in the leftmost row, one end portion of N-type thermoelectric conversion element 44 is electrically connected to one end portion of P-type thermoelectric conversion element 46 by electrode 48 located on the one substrate 38 side. In FIG. 4, one substrate 38 is omitted for the sake of convenience in illustration. In FIG. 4, among two thermoelectric converters 42 located in the leftmost row, the other end portion of P-type thermoelectric conversion element 46 of thermoelectric converter 42 on the lower side in FIG. 4 is electrically connected to the other end portion of N-type thermoelectric conversion element 44 of thermoelectric converter 42 on the upper side by electrode 48 disposed on the other substrate 40 side.

Moreover, in FIG. 4, the other end portion of P-type thermoelectric conversion element 46 in thermoelectric converter 42 located on the upper side in the leftmost row is electrically connected to the other end portion of N-type thermoelectric conversion element 44 in thermoelectric converter 42 located on the upper side in the second row from the leftmost row by electrode 48 disposed on the other substrate 40 side. This electrode 48 is formed into, for example, a polygonal flat-plate shape. By thus forming electrode 48 that electrically connects two thermoelectric converters 42, it is possible to suppress abnormal heat generation due to current concentration, compared with when that electrode 48 is formed into a rectangular shape. Likewise, P-type thermoelectric conversion element 46, N-type thermoelectric conversion element 44, P-type thermoelectric conversion element 46, ..., N-type thermoelectric conversion element 44, and P-type thermoelectric conversion element 46 are disposed zigzag in this order and electrically connected in series, as illustrated by a dash-dotted line in FIG. 4.

Extraction electrodes 50, 52 are respectively electrically connected to the other end portion of N-type thermoelectric conversion element 44 and the other end portion of P-type thermoelectric conversion element 46 that are disposed at ends of the plurality of N-type thermoelectric conversion elements 44 and the plurality of P-type thermoelectric conversion elements 46 that are connected in series. As illustrated in FIG. 3, wirings 54, 56 are electrically connected to these extraction electrodes 50, 52, respectively. In FIG. 4 and FIG. 5, wirings 54, 56 are omitted for the sake of convenience in illustration.

In the cross-sectional view in a plane approximately parallel to principal surface 40a of substrate 40 (or principal surface 38a of substrate 38) in FIG. 5, N-type thermoelectric conversion element 44 is formed into a rectangular shape (one example of an approximately rectangular shape), and includes first cross-sectional area $A_n$. P-type thermoelectric conversion element 46 is formed into a square shape (one example of an approximately rectangular shape), and includes second cross-sectional area $A_p$ smaller than first cross-sectional area $A_n$. It is preferable that first cross-sectional area $A_n$ is at least 1.5 times and at most 4 times second cross-sectional area $A_p$.

Furthermore, in the cross-sectional view in FIG. 5, thermoelectric converter 42 is disposed so that one side 44a (one example of a first side) of N-type thermoelectric conversion element 44 and one side 46a (one example of a second side) of P-type thermoelectric conversion element 46 face each other. One side 44a of N-type thermoelectric conversion element 44 and one side 46a of P-type thermoelectric conversion element 46 have approximately same length L. In the present specification, thermoelectric converters 42 disposed so that one side 44a of N-type thermoelectric conversion element 44 and one side 46a of P-type thermoelectric conversion element 46 have an approximately same length and face each other is referred to as "specific thermoelectric converters".

Thermoelectric converter 42 is disposed at least in the peripheral region of substrate 40 (or substrate 38). The peripheral region is a region in which N-type thermoelectric conversion element 44 and P-type thermoelectric conversion element 46 are disposed along the periphery of substrate 40 (or substrate 38) among the plurality of N-type thermoelectric conversion elements 44 and the plurality of P-type thermoelectric conversion elements 46 disposed on principal surface 40a of substrate 40 (or on principal surface 38a of substrate 38).

Hereinafter, the strength of thermoelectric conversion module 18 will be described with reference to FIG. 6 to FIG. 8. FIG. 6 is a diagram for illustrating compressive stress that works on thermoelectric conversion module 18 according to the embodiment. FIG. 7 is a diagram for illustrating shear stress that works on thermoelectric conversion module 18 according to the embodiment. FIG. 8 is a graph illustrating a relationship between strain and stress in thermoelectric conversion module 18 according to the embodiment.

As described above, in thermoelectric conversion module 18 according to the embodiment, first cross-sectional area $A_n$ of N-type thermoelectric conversion element 44 is greater than second cross-sectional area $A_p$ of P-type thermoelectric conversion element 46. As illustrated in FIG. 6, compressive stress $\tau_{1module}$ applied to thermoelectric conversion module 18 for generating compressive strain $\varepsilon_1$ in such thermoelectric conversion module 18 is expressed by the following Equation 1.

$$\tau_{1module} = \{A_p \times f_{1p}(\varepsilon_1) + A_n \times f_{1n}(\varepsilon_1)\} / (A_p + A_n) \quad \text{Equation 1}$$

In the above Equation 1, $f_{1p}$ and $f_{1n}$ are each a function that represents a compressive stress-compressive strain relationship in P-type thermoelectric conversion element 46 and N-type thermoelectric conversion element 44, respectively. Here, the following Equations 2 and 3 hold true for P-type thermoelectric conversion element 46 and N-type thermoelectric conversion element 44, respectively.

$$\tau_{1p} = f_{1p}(\varepsilon_{1p}) \quad \text{Equation 2}$$

$$\tau_{1n} = f_{1n}(\varepsilon_{1n}) \quad \text{Equation 3}$$

In the above Equation 2, $\tau_{1p}$ (one example of $\tau_{1\alpha}$) is compressive stress applied to P-type thermoelectric conversion element 46 for generating compressive strain $\varepsilon_{1p}$ in thermoelectric conversion module 18. Moreover, in the above Equation 3, $\tau_{1n}$ (one example of $\tau_{1\beta}$) is compressive stress applied to N-type thermoelectric conversion element 44 for generating compressive strain $\varepsilon_{1n}$ in thermoelectric conversion module 18.

As illustrated in FIG. 6, when compressive stress $\tau_{1module}$ is applied to thermoelectric conversion module 18, $\varepsilon_1 = \varepsilon_{1p} = \varepsilon_{1n}$ holds true when deformation from substrates 38, 40 to electrode 48 and deformation in a bonding portion between that electrode 48 and each of P-type thermoelectric conversion element 46 and N-type thermoelectric conversion element 44 is small enough to be ignored. Since this generates the same compressive strain $\varepsilon_1$ in P-type thermoelectric conversion element 46 and N-type thermoelectric conversion element 44, when $\tau_{1p} < \tau_{1n}$ holds true under the condition $\varepsilon_{1p} = \varepsilon_{1n}$, compressive stress $\tau_{1module}$ necessary for generating compressive strain $\varepsilon_1$ in thermoelectric conversion module 18 increases as first cross-sectional area $A_n$ increases to be greater than second cross-sectional area $A_p$, and the strength of the entire thermoelectric conversion module 18 increases.

As illustrated in FIG. 7, shear stress $\tau_{2module}$ applied to such thermoelectric conversion module 18 for generating shear strain $\varepsilon_2$ in thermoelectric conversion module 18 is expressed by the following Equation 4.

$$\tau_{2module} = \{A_p \times f_{2p}(\varepsilon_2) + A_n \times f_{2n}(\varepsilon_2)\} / (A_p + A_n) \qquad \text{Equation 4}$$

In the above Equation 4, $f_{2p}$ and $f_{2n}$ are each a function that represents a shear stress-shear strain relationship in P-type thermoelectric conversion element 46 and N-type thermoelectric conversion element 44, respectively. Here, the following Equations 5 and 6 hold true for P-type thermoelectric conversion element 46 and N-type thermoelectric conversion element 44, respectively.

$$\tau_{2p} = f_{2p}(\varepsilon_{2p}) \qquad \text{Equation 5}$$

$$\tau_{2n} = f_{2n}(\varepsilon_{2n}) \qquad \text{Equation 6}$$

In the above Equation 5, $\tau_{2p}$ (one example of $\tau_{2\alpha}$) is shear stress applied to P-type thermoelectric conversion element 46 for generating shear strain $\varepsilon_{2p}$ in thermoelectric conversion module 18. Moreover, in the above Equation 6, $\tau_{2n}$ (one example of $\tau_{2\beta}$) is shear stress applied to N-type thermoelectric conversion element 44 for generating shear strain $\varepsilon_{2n}$ in thermoelectric conversion module 18.

As illustrated in FIG. 7, when shear stress $\tau_{2module}$ is applied to thermoelectric conversion module 18, $\varepsilon_2 = \varepsilon_{2p} = \varepsilon_{2n}$ holds true when deformation from substrates 38, 40 to a bonding portion is small enough to be ignored. Since this generates the same shear strain $\varepsilon_2$ in P-type thermoelectric conversion element 46 and N-type thermoelectric conversion element 44, when $\tau_{2p} < \tau_{2n}$ holds true under the condition $\varepsilon_{2p} = \varepsilon_{2n}$, shear stress $\tau_{2module}$ necessary for generating shear strain $\varepsilon_2$ in thermoelectric conversion module 18 increases as first cross-sectional area $A_n$ increases to be greater than second cross-sectional area $A_p$, and the strength of the entire thermoelectric conversion module 18 increases.

In thermoelectric conversion module 18 according to the embodiment, when N-type thermoelectric conversion element 44 excels more than P-type thermoelectric conversion element 46 both in a gradient (elastic modulus) in a stress-strain curve and in a breaking strength, by applying a structure in which first cross-sectional area $A_n$ of N-type thermoelectric conversion element 44 is greater than second cross-sectional area $A_p$ of P-type thermoelectric conversion element 46, thermoelectric conversion module 18 has excellent properties in terms of breaking strength. Regarding the direction of applying stress or strain, thermoelectric conversion module 18 may have excellence in either a compression direction or a shear direction. When N-type thermoelectric conversion element 44 excels more than P-type thermoelectric conversion module 46 in a compression direction, thermoelectric conversion module 18 that is strong against compressive stress is achieved. When N-type thermoelectric conversion element 44 excels more than P-type thermoelectric conversion module 46 in a shear direction, thermoelectric conversion module 18 that is strong against shear stress is achieved. In other words, at least one of the condition expressed by $\tau_{1n} > \tau_{1p}$ or the condition expressed by $\tau_{2n} > \tau_{2p}$ may be satisfied.

Typical behaviors in the stress-strain curves of thermoelectric conversion module 18 according to the embodiment, N-type thermoelectric conversion element 44, and P-type thermoelectric conversion element 46, i.e., typical behaviors in the relationship between stress $\tau$ and strain $\varepsilon$, are schematically illustrated in FIG. 8. FIG. 8 illustrates stress applied when strain is added to thermoelectric conversion module 18, N-type thermoelectric conversion element 44, and P-type thermoelectric conversion element 46. As illustrated in FIG. 8, thermoelectric conversion module 18, N-type thermoelectric conversion element 44, and P-type thermoelectric conversion element 46 are fractured (broke) at a stress value or a strain value indicated by a black circle.

As indicated by the solid line on the lower side in FIG. 8, the stress-strain curve of P-type thermoelectric conversion element 46 (a chalcogenide element) that includes a chalcogenide compound represented by a $Bi_2Te_3$

compound and a GeTe compound is straight and P-type thermoelectric conversion element 46 is fractured at a low stress value or a low strain value. In contrast, as indicated by the solid line on the upper side in FIG. 8, the stress-strain curve of N-type thermoelectric conversion element 44 (a $Mg_3Sb_2$ element) that includes a $Mg_3Sb_2$ compound is slightly curved and N-type thermoelectric conversion element 44 is fractured at a high stress value or a high strain value. Such N-type thermoelectric conversion element 44 therefore excels in strength and attributes among other N-type thermoelectric conversion elements. In other words, compressive fracture stress $\tau_{1n, max}$ that is compressive stress by which N-type thermoelectric conversion element 44 is fractured is greater than shear fracture stress $\tau_{1p, max}$ that is shear stress by which P-type thermoelectric conversion element 46 is fractured. Shear fracture stress $\tau_{2n, max}$ that is shear stress by which N-type thermoelectric conversion element 44 is fractured is greater than shear fracture stress $\tau_{2p, max}$ that is shear stress by which P-type thermoelectric conversion element 46 is fractured. Here, at least one of the condition $\tau_{1n, max} > \tau_{1p, max}$ or the condition $\tau_{2n, max} > \tau_{2p, max}$ may be satisfied. NPL 2 discloses that the fracture toughness value of a $Mg_3Sb_2$ element indicates, as a characteristic correlated with breaking strength, a value three times as excellent as the fracture toughness value of a $Bi_2Te_3$ element.

Two dashed line graphs in FIG. 8 each indicate the stress-strain curve of thermoelectric conversion module 18 predicted based on the above Equation (1) using two cross-sectional area ratio conditions ($A_p$:$A_n$ = 1:2 and $A_p$:$A_n$ = 2:1) between N-type thermoelectric conversion element 44 and P-type thermoelectric conversion element 46. When stress-strain curve gradient $df/d\varepsilon$ referred to as, for instance, a shear elastic modulus or a lateral elastic modulus is more excellent in N-type thermoelectric conversion element 44 than in P-type thermoelectric conversion element 46, maximum stress necessary for generating strain that reaches fracture increases, i.e., the strength of thermoelectric conversion module 18 increases by increasing the proportion of first cross-sectional area $A_n$ of N-type thermoelectric conversion element 44.

NPL 3 and NPL 4 disclose a simulation result based on a first-principles calculation for the stress-strain curve of $Mg_3Sb_2$ and $Bi_2Te_3$. These literatures disclose that the modulus of transverse elasticity of $Mg_3Sb_2$ is 12 GPa and the modulus of transverse elasticity of $Bi_2Te_3$ is approximately 4 GPa to 6 GPa. In other words, the strength of thermoelectric conversion module 18 is increased by increasing the proportion of first cross-sectional area $A_n$. Specifically, by selecting at least 2 for the value of cross-sectional ratio $A_n/A_p$, the modulus of longitudinal elasticity of thermoelectric conversion module 18 reaches approximately 9 GPa to 10 GPa that is comparable to a simple substance of $Mg_3Sb_2$. Thus, the effect of increasing the strength of thermoelectric conversion module 18 produced by increasing the proportion of first cross-sectional area $A_n$ of a $Mg_3Sb_2$ compound can be obtained when not only a $Bi_2Te_3$ compound but also a typical chalcogenide compound such as a GeTe compound is used as the material of P-type thermoelectric conversion element 46.

Moreover, since a chalcogenide material uses, as a main component, selenium (Se) and tellurium (Te) that are rare elements, increasing the value of cross-sectional area ratio $A_n/A_p$ leads to suppressing the use of such rare elements. Therefore, thermoelectric conversion module 18 according to the embodiment is useful even in terms of environmental harmony improvement.

Next, thermoelectric conversion properties of thermoelectric conversion module 18 will be described. When thermoelectric conversion module 18 in which N-type thermoelectric conversion element 44 and P-type thermoelectric conversion element 46 having different cross-sectional areas are combined is used for thermoelectric power generation or thermoelectric cooling, thermoelectric conversion performance of thermoelectric conversion module 18 decreases since conditions for optimal driving current are normally different between N-type thermoelectric conversion element 44 and P-type thermoelectric conversion element 46. In order to avoid this problem, it is effective to increase the carrier concentration of P-type thermoelectric conversion element 46 and suppress the carrier concentration of N-type thermoelectric conversion element 44.

When Seebeck coefficients are defined to be $S_p$ and $S_n$, electrical conductivity rates are defined to be $\sigma_p$ and $\sigma_n$, and heat conductivity rates are defined to be $\kappa_p$ and $\kappa_n$, for P-type thermoelectric conversion element 46 and N-type thermoelectric conversion element 44, respectively, in the operating temperature range of thermoelectric conversion module 18, cross-sectional area ratio $A_n/A_p$ that maximizes thermal power generation efficiency or cooling coefficient of performance (COP) is expressed by the following Equation 7.
Math. 1

$$A_n / A_p = \sqrt{\sigma_p \kappa_p / \sigma_n \kappa_n}$$

Equation 7

Cross-sectional area ratio $A_n/A_p$ that maximizes power generation density or endothermic density per unit area is expressed by the following Equation 8.

$$A_n/A_p = \sigma_p|S_p| / \sigma_n|S_n| \quad \text{Equation 8}$$

Since each of the above Equations 7 and 8 is a decreasing function with respect to $\sigma_n/\sigma_p$, and $\sigma_p$ and $\sigma_n$ are proportional to carrier concentration in first approximation, by decreasing carrier concentration ratio $N_n/N_p$ between N-type thermoelectric conversion element 44 and P-type thermoelectric conversion element 46, it is possible to maximize the thermoelectric conversion properties of thermoelectric conversion module 18.

As one example, $Bi_{0.5}Sb_{1.5}Te_3$ ($S_p$ = 180 $\mu$V/K, $\sigma_p$ = 1000 S/cm, $\kappa_p$ = 1.5 W/mK) is used as P-type thermoelectric conversion element 46, and $Mg_{3.2}SbBi_{0.998}Te_{0.002}$ ($S_n$ = -220 pV/K, $\sigma_n$ = 400 S/cm, $K_n$ = 0.9 W/mK) is used as N-type thermoelectric conversion element 44. In this case, cross-sectional area ratio $A_n/A_p$ that maximizes power generation efficiency or cooling coefficient of performance is 2.04 and cross-sectional area ratio $A_n/A_p$ that maximizes power generation density and endothermic density is 2.05. By manufacturing thermoelectric conversion module 18 having such a cross-sectional area ratio, it is possible to achieve both the maximization of properties and an increase in the strength of thermoelectric conversion module 18. It is also possible to further increase cross-sectional area ratio $A_n/A_p$ by decreasing the amount of Te in N-type thermoelectric conversion element 44 to decrease $\sigma_n$ or by doping $Bi_{0.5}Sb_{1.5}Te_3$ with copper (Cu) or stannum (Sn).

When the electrical conductivity of N-type thermoelectric conversion element 44 at a room temperature is defined as $\sigma_n$ and the electrical conductivity of P-type thermoelectric conversion element 46 at a room temperature is defined as $\sigma_p$, it is preferable to satisfy a condition expressed by $2 \leq \sigma_p / \sigma_n \leq 4$. Moreover, it is preferable that $\sigma_p$ satisfies a condition expressed by 400 S/cm $\leq \sigma_p \leq$ 4000 S/cm, and $\sigma_n$ satisfies a condition expressed by 100 S/cm $\leq \sigma_n \leq$ 1000 S/cm.

[3. Advantageous Effects]

As described above, in the present embodiment, in the plan view illustrated in FIG. 5, first cross-sectional area $A_n$ of N-type thermoelectric conversion element 44 that includes, for example, a $Mg_3Sb_2$ compound is greater than second cross-sectional area $A_p$ of P-type thermoelectric conversion element 46 that includes, for example, a chalcogenide compound. Moreover, one side 44a of N-type thermoelectric conversion element 44 and one side 46a of P-type thermoelectric conversion element 46 have an approximately same length L and are disposed to face each other.

This can increase the strength of thermoelectric conversion module 18 while enhancing thermoelectric conversion efficiency. As a result, even when impact or vibrations are added to thermoelectric conversion module 18, it is possible to inhibit thermoelectric conversion module 18 from being damaged.

[4. Variations of Thermoelectric Conversion Module]

[4-1. Variation 1]

The configuration of thermoelectric conversion module 18A according to Variation 1 of the embodiment will be described with reference to FIG. 9. FIG. 9 is a plan view illustrating thermoelectric conversion module 18A according to Variation 1 of the embodiment, from which one substrate 38 is omitted. In the present variation, elements same as the elements described in the above embodiment share same reference numerals and description thereof is omitted. In FIG. 9, the illustration of electrode 48 is omitted for the sake of convenience in illustration.

As illustrated in FIG. 9, in thermoelectric conversion module 18A according to Variation 1, the shapes of N-type thermoelectric conversion element 44A and P-type thermoelectric conversion element 46A in thermoelectric converter 42A are respectively different from the shapes of N-type thermoelectric conversion element 44 and P-type thermoelectric conversion element 46 in thermoelectric converter 42 described above. Specifically, in a cross-sectional view in a plane approximately parallel to principal surface 40a of substrate 40, N-type thermoelectric conversion element 44A is formed in a square shape (one example of an approximately rectangular shape) and P-type thermoelectric conversion element 46A is formed into a rectangular shape (one example of an approximately rectangular shape).

In the present variation, it is possible to obtain the same advantageous effects as obtained by the thermoelectric conversion module according to the above embodiment.

[4-2. Variation 2]

The configuration of thermoelectric conversion module 18B according to Variation 2 of the embodiment will be described with reference to FIG. 10. FIG. 10 is a plan view illustrating thermoelectric conversion module 18B according to Variation 2 of the embodiment, from which one substrate 38 is omitted. In the present variation, elements same as the elements described in the above embodiment share same reference numerals and description thereof is omitted. In FIG. 10, the illustration of electrode 48 is omitted for the sake of convenience in illustration.

As illustrated in FIG. 10, in thermoelectric conversion module 18B according to Variation 2, the arrangement of a plurality of thermoelectric converters 42 is different from that of the plurality of thermoelectric converters in thermoelectric conversion module 18 according to the above embodiment. Specifically, N-type thermoelectric conversion element 44, P-type thermoelectric conversion element 46, N-type thermoelectric conversion element 44, P-type thermoelectric conversion element 46, ..., P-type thermoelectric conversion element 46, and N-type thermoelectric conversion element 44 are disposed zigzag in this order and are electrically connected in series. This allows the arrangement of N-type thermoelectric conversion elements 44 and P-type thermoelectric conversion elements 46 at high density.

Moreover, in a cross-sectional view in a plane approximately parallel to principal surface 40a of substrate 40, length L1 of the longer side of each of N-type thermoelectric conversion elements 44 is at least two times length L2 of one side of each of P-type thermoelectric conversion elements 46. In this case, a space may be provided between two P-type thermoelectric conversion elements 46 adjacent to each other in the long side direction of N-type thermoelectric conversion element 44. This allows the arrangement of N-type thermoelectric conversion elements 44 and P-type thermoelectric conversion elements 46 at high density.

Moreover, the number of N-type thermoelectric conversion elements 44 arranged in the peripheral region of substrate 40 is greater than the number of P-type thermoelectric conversion elements 46 arranged in the peripheral region of substrate 40. With this, it is possible to effectively increase the strength of thermoelectric conversion module 18B in the peripheral region of substrate 40 of thermoelectric conversion module 18B.

[4-3. Variation 3]

The configuration of thermoelectric conversion module 18C according to Variation 3 of the embodiment will be described with reference to FIG. 11. FIG. 11 is a plan view illustrating thermoelectric conversion module 18C according to Variation 3 of the embodiment, from which one substrate 38 is omitted. In the present variation, elements same as the elements described in the embodiment and Variation 1 described above share same reference numerals and description thereof is omitted. In FIG. 11, the illustration of electrode 48 is omitted for the sake of convenience in illustration.

As illustrated in FIG. 11, the arrangement of N-type thermoelectric conversion element 44A in thermoelectric conversion module 18C according to Variation 3 is different from that in thermoelectric conversion module 18 according to the above embodiment. Specifically, as indicated by dash-dotted line in FIG. 11, N-type thermoelectric conversion element 44A, P-type thermoelectric conversion element 46A, N-type thermoelectric conversion element 44A, P-type thermoelectric conversion element 46A, ..., P-type thermoelectric conversion element 46A, and N-type thermoelectric conversion element 44A are disposed zigzag in this order and electrically connected in series, like Variation 2 described above.

Moreover, N-type thermoelectric conversion element 44A is disposed at a location closest to a corresponding one of four vertexes 40b on principal surface 40a of substrate 40. In other words, four N-type thermoelectric conversion elements 44A are disposed at the four corners (or in the vicinity of the four corners) of principal surface 40a of substrate 40.

Since stress concentrates at the four corners of substrate 40 in thermoelectric conversion module 18C in many cases, practically, it is possible to increase strength at the four corners of substrate 40 in thermoelectric conversion module 18C by disposing N-type thermoelectric conversion elements 44A at a location where strain easily generates. In this case, the elastic modulus of N-type thermoelectric conversion element 44A may be less than the elastic modulus of P-type thermoelectric conversion element 46A, and the strength of thermoelectric conversion module 18C can be increased if the elastic modulus of N-type thermoelectric conversion element 44A excels only in breaking strength.

[4-4. Variation 4]

The configuration of thermoelectric conversion module 18D according to Variation 4 of the embodiment will be described with reference to FIG. 12. FIG. 12 is a plan view illustrating thermoelectric conversion module 18D according to Variation 4 of the embodiment, from which one substrate 38 is omitted. In the present variation, elements same as the elements described in the embodiment described above share same reference numerals and description thereof is omitted. In FIG. 12, the illustration of electrode 48 is omitted for the sake of convenience in illustration.

In thermoelectric conversion module 18D according to Variation 4, as illustrated by a dash-dotted line in FIG. 12, N-type thermoelectric conversion element 44, P-type thermoelectric conversion element 46, N-type thermoelectric conversion element 44, ..., P-type thermoelectric conversion element 46, P-type thermoelectric conversion element 46, and N-type thermoelectric conversion element 44 are disposed zigzag in this order and electrically connected in series, like Variation 3 described above.

Moreover, N-type thermoelectric conversion element 44 is disposed at a location closest to a corresponding one of four vertexes 40b on principal surface 40a of substrate 40. In other words, four N-type thermoelectric conversion elements 44 are disposed at the four corners (or in the vicinity of the four corners) of principal surface 40a of substrate 40. With thermoelectric conversion module 18D according to the present variation, it is possible to obtain the same effects as obtained in Variation 3 described above.

(Other Embodiments)

Although the thermoelectric conversion module according to one or more aspects of the present disclosure has been described based on the embodiment and each of variations thereof, the present disclosure is not limited to these embodiment and variations. Other embodiments obtained by various modifications to any of the embodiment and the variations which may be conceived by those skilled in the art may be also included in the scope of the one or more aspects of the present disclosure so long as they do not depart from the essence of the present disclosure.

In each of the embodiment and the variations thereof, a high-temperature fluid is exhaust gas while a low-temperature fluid is cold water or a cold wind, but the present disclosure is not limited to this example. Each of the high-temperature fluid and the low-temperature fluid may be any liquid or gas.

Moreover, in each of the embodiment and the variations thereof, thermoelectric conversion module 18 (18A, 18B, 18C, 18D, or 20) is used in thermoelectric power generation that uses Seebeck effect, but the present disclosure is not limited to this example, and may be used for thermoelectric cooling (or thermoelectric heating) that uses Peltier effect. In this case, by allowing current to flow through thermoelectric conversion module 18 (18A, 18B, 18C, 18D, or 20), heat can be transferred by the current. This enables precise temperature control by heating or cooling.

[Industrial Applicability]

A thermoelectric conversion module according to the present disclosure can be used in generators that use thermal energy of exhaust gas exhausted from, for example, vehicles or factories, or can be used for temperature adjustment of precision machines such as electronic devices or optical devices.

[Reference Signs List]

| | |
|---|---|
| 2 | thermoelectric conversion device |
| 4, 6 | low-temperature fluid flow path |
| 8, 10 | lateral-face binder |
| 12 | high-temperature fluid flow path |
| 14 | high-temperature fluid entrance |
| 16 | high-temperature fluid exit |
| 18, 18A, 18B, 18C, 18D, 20 | thermoelectric conversion module |
| 22, 30 | case |
| 24, 32 | low-temperature fluid entrance |
| 26, 34 | low-temperature fluid exit |
| 28, 36 | low-temperature fluid flow path |
| 38, 40 | substrate |
| 38a, 40a | principal surface |
| 40b | vertex |
| 42, 42A | thermoelectric converter |
| 44, 44A | N-type thermoelectric conversion element |
| 44a, 46a | one side |
| 46, 46A | P-type thermoelectric conversion element |
| 48 | electrode |
| 50, 52 | extraction electrode |
| 54, 56 | wiring |

**Claims**

1.   A thermoelectric conversion module comprising:

a substrate including a principal surface; and
a plurality of thermoelectric converters arranged on the principal surface of the substrate, wherein
each of the plurality of thermoelectric converters includes:

a first thermoelectric conversion element having a first cross-sectional area in a cross-sectional view in a plane approximately parallel to the principal surface;

a second thermoelectric conversion element having a second cross-sectional area in the cross-sectional view, the second cross-sectional area being smaller than the first cross-sectional area; and
an electrode that electrically connects one end portion of the first thermoelectric conversion element to one end portion of the second thermoelectric conversion element,

at least one of a first condition expressed by $\tau_{1\alpha} > \tau_{1\beta}$ or a second condition expressed by $\tau_{2\alpha} > \tau_{2\beta}$ is satisfied, in the first condition:

$\tau_{1\alpha}$ denotes compressive stress applied to the first thermoelectric conversion element for generating compressive strain $\varepsilon_1$ in the thermoelectric conversion module; and
$\tau_{1\beta}$ denotes compressive stress applied to the second thermoelectric conversion element for generating the compressive strain $\varepsilon_1$ in the thermoelectric conversion module, and

in the second condition:

$\tau_{2\alpha}$ denotes shear stress applied to the first thermoelectric conversion element for generating shear strain $\varepsilon_2$ in the thermoelectric conversion module; and
$\tau_{2\beta}$ denotes shear stress applied to the second thermoelectric conversion element for generating the shear strain $\varepsilon_2$ in the thermoelectric conversion module.

2. The thermoelectric conversion module according to claim 1, wherein

the first thermoelectric conversion element is an N-type thermoelectric conversion element, and
the second thermoelectric conversion element is a P-type thermoelectric conversion element.

3. A thermoelectric conversion module comprising:

a substrate including a principal surface; and
a plurality of thermoelectric converters arranged on the principal surface of the substrate, wherein
each of the plurality of thermoelectric converters includes:

an N-type thermoelectric conversion element formed into an approximately rectangular shape and having a first cross-sectional area in a cross-sectional view in a plane approximately parallel to the principal surface;
a P-type thermoelectric conversion element formed into an approximately rectangular shape and having a second cross-sectional area in the cross-sectional view, the second cross-sectional area being smaller than the first cross-sectional area; and
an electrode that electrically connects one end portion of the N-type thermoelectric conversion element to one end portion of the P-type thermoelectric conversion element,

the N-type thermoelectric conversion element contains Mg, and
specific thermoelectric converters, among the plurality of thermoelectric converters, are disposed such that a first side of the N-type thermoelectric conversion element and a second side of the P-type thermoelectric conversion element face each other in the cross-sectional view, the first side having an approximately same length as the second side.

4. The thermoelectric conversion module according to any one of claims 1 to 3, wherein
the first cross-sectional area is at least 1.5 times and at most 4 times the second cross-sectional area.

5. The thermoelectric conversion module according to claim 3, wherein

the specific thermoelectric converters are disposed at least in a peripheral region of the substrate, and
the peripheral region is a region in which the N-type thermoelectric conversion element and the P-type thermoelectric conversion element are disposed along a periphery of the substrate, the N-type thermoelectric conversion element and the P-type thermoelectric conversion element being among the N-type thermoelectric conversion elements and the P-type thermoelectric conversion elements arranged on the principal surface of the substrate.

6. The thermoelectric conversion module according to claim 5, wherein

two or more specific thermoelectric converters are electrically connected in series in a first direction and are arranged adjacent to each other in a second direction orthogonal to the first direction, the two or more specific thermoelectric converters being the specific thermoelectric converters.

7. The thermoelectric conversion module according to claim 2 or 5, wherein

the substrate is of a polygonal shape including vertexes, and
each of the N-type thermoelectric conversion elements is disposed in a position closest to a corresponding one of the vertexes on the principal surface of the substrate.

8. The thermoelectric conversion module according to claim 2 or 5, wherein
in the cross-sectional view, a length of a longer side of each of the N-type thermoelectric conversion elements is at least two times a length of any one side of each of the P-type thermoelectric conversion elements.

9. The thermoelectric conversion module according to claim 5, wherein
a total number of the N-type thermoelectric conversion elements arranged in the peripheral region is greater than a total number of the P-type thermoelectric conversion elements arranged in the peripheral region.

10. The thermoelectric conversion module according to claim 2, wherein
compressive fracture stress $\tau_{1n,max}$ of the N-type thermoelectric conversion element is greater than compressive fracture stress $\tau_{1p,max}$ of the P-type thermoelectric conversion element, or shear fracture stress $\tau_{2n,max}$ of the N-type thermoelectric conversion element is greater than shear fracture stress $\tau_{2p,max}$ of the P-type thermoelectric conversion element.

11. The thermoelectric conversion module according to claim 2, wherein

a third condition expressed by $2 \leq \sigma_p / \sigma_n \leq 4$ is satisfied, and
in the third condition:

$\sigma_n$ denotes an electrical conductivity of the N-type thermoelectric conversion element at a room temperature; and
$\sigma_p$ denotes an electrical conductivity of the P-type thermoelectric conversion element at a room temperature.

12. The thermoelectric conversion module according to claim 11, wherein
$\sigma_p$ satisfies a condition expressed by 400 S/cm $\leq \sigma_p \leq$ 4000 S/cm.

13. The thermoelectric conversion module according to claim 11 or 12, wherein
$\sigma_n$ satisfies a condition expressed by 100 S/cm $\leq \sigma_n \leq$ 1000 S/cm.

14. The thermoelectric conversion module according to claim 2 or 3, wherein
the P-type thermoelectric conversion element includes a chalcogenide compound.

15. The thermoelectric conversion module according to claim 14, wherein
the P-type thermoelectric conversion element includes a $(Bi, Sb)_2(Se, Te)_3$ compound or a $(Ge, Sn, Pb)_a(Sb, Bi)_b(Mg, Mn, Ti, In, Cr, Ag, Zn)_c(S, Se, Te)$ compound.

16. The thermoelectric conversion module according to claim 3, wherein
the N-type thermoelectric conversion element further contains at least one of Sb or Bi.

17. The thermoelectric conversion module according to claim 16, wherein
the N-type thermoelectric conversion element includes a $Mg_3(Sb, Bi)_2$ compound.

18. A thermoelectric conversion device comprising:

a first fluid flow path along which a first fluid flows;
a second fluid flow path along which a second fluid flows; and
the thermoelectric conversion module according to any one of claims 1 to 3 that converts thermal energy generated by a temperature difference between the first fluid and the second fluid into electric power.

19. A power generation method comprising:

giving a temperature difference to the thermoelectric conversion module according to any one of claims 1 to 3; and extracting electric power based on thermoelectromotive force generated in each of the plurality of thermoelectric converters in the thermoelectric conversion module due to the temperature difference.

20. A heat conduction method comprising:

allowing current to flow through the thermoelectric conversion module according to any one of claims 1 to 3; and transferring heat by the current.

# FIG. 1

Low-temperature fluid

2

26

16

22

24  10  4

Low-temperature fluid

High-temperature fluid

14

30  6  8  34

Low-temperature fluid

32  12

High-temperature fluid

Low-temperature fluid

Z
Y   X

# FIG. 2

EP 4 546 997 A1

# FIG. 3

# FIG. 4

# FIG. 5

# FIG. 6

18

Compressive
strain $\varepsilon_1$

38

N 44

P 46

40

Compressive stress $\tau_{1module}$

FIG. 7

Shear stress $\tau_{2module}$

Shear strain $\varepsilon_2$

18

38

40

46

44

P

N

FIG. 8

$(\varepsilon n, max, \ \tau n,max)$

Mg₃Sb₂ element

Stress $\tau$

Ap:An = 1:2
Ap:An = 2:1
Chalcogenide element

Strain $\varepsilon$

$(\varepsilon p,max, \ \tau p,max)$

# FIG. 9

EP 4 546 997 A1

# FIG. 10

# FIG. 11

# FIG. 12

## INTERNATIONAL SEARCH REPORT

| International application No. |
| --- |
| **PCT/JP2023/021618** |

### A. CLASSIFICATION OF SUBJECT MATTER

*H10N 10/13*(2023.01)i; *H10N 10/17*(2023.01)i; *H10N 10/852*(2023.01)i
FI: H10N10/17 A; H10N10/852; H10N10/13

According to International Patent Classification (IPC) or to both national classification and IPC

### B. FIELDS SEARCHED

Minimum documentation searched (classification system followed by classification symbols)

H10N10/13; H10N10/17; H10N10/852

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
| --- | --- | --- |
| X | JP 2009-088457 A (IBIDEN CO., LTD.) 23 April 2009 (2009-04-23) paragraphs [0003], [0020]-[0039], fig. 1-4 | 1, 4, 19, 20 |
| Y | | 2, 3, 5-10, 14-18 |
| A | | 11-13 |
| Y | JP 2013-012571 A (PANASONIC CORP.) 17 January 2013 (2013-01-17) paragraph [0012], fig. 1 | 2, 3, 5-10, 14-18 |
| Y | WO 2017/072982 A1 (PANASONIC INTELLECTUAL PROPERTY MANAGEMENT CO., LTD.) 04 May 2017 (2017-05-04) paragraphs [0018]-[0033], fig. 1 | 3, 5-9, 14-18 |
| Y | WO 2021/256163 A1 (PANASONIC INTELLECTUAL PROPERTY MANAGEMENT CO., LTD.) 23 December 2021 (2021-12-23) paragraphs [0031]-[0045], fig. 1-3 | 18 |

☐ Further documents are listed in the continuation of Box C.      ☑ See patent family annex.

| | |
| --- | --- |
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| **16 August 2023** | **29 August 2023** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (January 2015)

International application No.

**PCT/JP2023/021618**

| Patent document cited in search report | | | Publication date (day/month/year) | Patent family member(s) | | | Publication date (day/month/year) |
|---|---|---|---|---|---|---|---|
| JP | 2009-088457 | A | 23 April 2009 | (Family: none) | | | |
| JP | 2013-012571 | A | 17 January 2013 | (Family: none) | | | |
| WO | 2017/072982 | A1 | 04 May 2017 | US | 2017/0117453 | A1 | |
| | | | | paragraphs [0054]-[0071], fig. 1 | | | |
| | | | | EP | 3179526 | A1 | |
| | | | | CN | 107078201 | A | |
| WO | 2021/256163 | A1 | 23 December 2021 | US | 2023/0081621 | A1 | |
| | | | | paragraphs [0039]-[0053], fig. 1-3 | | | |
| | | | | EP | 4167465 | A1 | |
| | | | | CN | 115699554 | A | |

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 6127281 B

- JP 2013012571 A

**Non-patent literature cited in the description**

- **H. TAMAKI et al.** *Advanced Materials*, 2016, vol. 28, 10182
- **R. SHU et al.** *Adv. Funct, Mater.*, 2019, vol. 29, 1807235

- **G. LI et al.** *J. Mater. Chem. A*, 2017, vol. 5, 9050
- **G. LI et al.** *Phys. Rev. Lett.*, 2017, vol. 119, 085501